# EUROPEAN PATENT APPLICATION

(11) **EP 4 779 326 A1**
(43) Date of publication of application: **22.07.2026**
(21) Application number: 24864000.5
(22) Date of filing: 29.02.2024
(51) Int. Cl.: G01R 19/00

(54) **CURRENT EFFECTIVENESS DETECTION METHOD, POWER SUPPLY SYSTEM, MEDIUM, AND DEVICE**

(30) Priority: 14.09.2023 CN 202311194757
(71) Applicant: BYD Company Limited, Shenzhen, Guangdong 518118 (CN)
(72) Inventor: SHI, Qian, Shenzhen, Guangdong 518118 (CN)
(74) Representative: Gunzelmann, Rainer
(86) International application number: PCT/CN2024/079432
(87) International publication number: WO 2025/055273

(57) **Abstract**

A current validity detection method, a power supply system, a medium, and a device are provided. The method includes: when a battery module is in a conducting state and a heating circuit heats the battery module, obtaining a voltage value and an effective resistance value of the heating circuit, and a first current sampling value of the battery module, where the battery system includes the battery module and the heating circuit connected in parallel, and the first current sampling value is an output current sampling value of the battery module; determining an actual current value of the heating circuit according to the voltage value and the effective resistance value of the heating circuit; and a detection result is obtained by at least detecting validity of the first current sampling value according to the actual current value.

## Description

### CROSS-REFERENCE TO RELATED APPLICATIONS

The present disclosure claims priority to Chinese Patent Application No. 202311194757.4, filed with the China National Intellectual Property Administration on September 14, 2023 and entitled "CURRENT VALIDITY DETECTION METHOD, POWER SUPPLY SYSTEM, MEDIUM, AND DEVICE", which is incorporated herein by reference in its entirety.

### TECHNICAL FIELD

The present disclosure relates to the field of vehicle technologies, and specifically, to a current validity detection method, a power supply system, a medium, and a device.

### BACKGROUND

In a new energy vehicle, a battery is used to provide power or meet another energy demand for a vehicle. During operation of a battery, there is a need to monitor a battery current, so as to prevent damage to the battery caused by an excessively large current, or failure of the vehicle to travel normally caused by an excessively small current. Currently, when a current of a battery is monitored, a current collection unit may be mounted on a main circuit of the battery to collect a main circuit current, so as to ensure that the battery operates under a normal condition, thereby ensuring safety of the battery.

### SUMMARY

An objective of the present disclosure is to provide a current validity detection method, a power supply system, a medium, and a device, so that validity detection is performed on a current of a battery system without additionally increasing a structure and costs of the battery system, thereby improving accuracy of monitoring the battery system and further improving safety of a vehicle.

To achieve the foregoing objective, a first aspect of the present disclosure provides a current validity detection method applied to a battery system, and the battery system includes a battery module and a heating circuit connected in parallel. The method includes:
when the battery module is in a conducting state and the heating circuit heats the battery module, obtaining a voltage value and an effective resistance value of the heating circuit, and obtaining a first current sampling value of the battery module, where the first current sampling value is an output current sampling value of the battery module;
determining an actual current value of the heating circuit according to the voltage value and the effective resistance value of the heating circuit; and
obtaining a detection result by at least detecting validity of the first current sampling value according to the actual current value.

Optionally, a heating apparatus is disposed in the heating circuit, and the obtaining an effective resistance value of the heating circuit includes:
obtaining a temperature value of the heating apparatus; and
determining a resistance value corresponding to the temperature value according to a preset corresponding relationship between temperature value and resistance value, and determining the resistance value as the effective resistance value of the heating circuit.

Optionally, a contactor is further disposed in the heating circuit, and the contactor is connected in series with the heating apparatus. The method further includes:
in response to a request for detecting the validity of the first current sampling value of the battery module, controlling the contactor to be closed, so that the heating apparatus heats the battery module.

Optionally, the obtaining a voltage value of the heating circuit includes:
obtaining a voltage of each cell in the battery module;
determining a total voltage of the battery module according to the voltage of each cell; and
determining the total voltage as the voltage value of the heating circuit.

Optionally, the obtaining a voltage value of the heating circuit further includes:
obtaining a voltage across the battery module collected by a voltage collection apparatus; and
detecting validity of the total voltage according to the voltage across the battery module; and
the determining the total voltage as the voltage value of the heating circuit includes:
   determining the total voltage as the voltage value of the heating circuit when the total voltage is determined to be valid.

Optionally, the detecting validity of the total voltage according to the voltage across the battery module includes:
determining a voltage deviation value between the voltage across the battery module and the total voltage; and
when the voltage deviation value is less than or equal to a preset voltage deviation threshold, the total voltage is determined to be valid.

Optionally, the obtaining a detection result by at least detecting validity of the first current sampling value according to the actual current value includes:
obtaining a load terminal state of the battery system, where the load terminal state includes a conducting state and a non-conducting state;
determining a current reference value according to the load terminal state and the actual current value; and
detecting the validity of the first current sampling value according to the current reference value to obtain the detection result.

Optionally, the detecting the validity of the first current sampling value according to the current reference value to obtain the detection result includes:
determining a current deviation value between the current reference value and the first current sampling value;
when the current deviation value is greater than a current deviation threshold, the first current sampling value is determined to be invalid; and
when the current deviation value is less than or equal to the current deviation threshold, the first current sampling value is determined to be valid.

Optionally, the determining a current reference value according to the load terminal state and the actual current value includes:
when the load terminal state is the non-conducting state, determining the actual current value as the current reference value; and
when the load terminal state is the conducting state, obtaining a current value of the load terminal, and determining a sum of the actual current value and the current value of the load terminal as the current reference value.

Optionally, when the detection result indicates that the first current sampling value is invalid, the method further includes:
controlling the battery module to switch to the non-conducting state after preset duration; and/or
sending a first invalidity prompt message to a vehicle controller, where the first invalidity prompt message is used to prompt the vehicle controller that the first current sampling value of the battery module is invalid.

Optionally, the method further includes:
obtaining a second current sampling value of the battery module when the battery module is in the non-conducting state; and
if the second current sampling value is greater than a zero-drift error threshold, the second current sampling value is determined to be invalid.

Optionally, when the second current sampling value is determined to be invalid, the method further includes:
sending a second invalidity prompt message to the vehicle controller, where the second invalidity prompt message is used to prompt the vehicle controller that the second current sampling value of the battery module is invalid; and/or
prohibiting switching the battery module to the conducting state.

Optionally, the battery module includes a plurality of batteries connected in series, or the battery module includes a plurality of parallel branches, and each branch includes at least one battery.

A second aspect of the present disclosure further provides a power supply system, and the system includes: a battery system and a management apparatus. The battery system includes a battery module and a heating circuit connected in parallel. The heating circuit is configured to heat the battery module, and the management apparatus is separately connected to the battery module and the heating circuit.

The management apparatus is configured to: when the battery module is in a conducting state and the heating circuit heats the battery module, obtain a voltage value and an effective resistance value of the heating circuit, and obtain a first current sampling value of the battery module, where the first current sampling value is an output current sampling value of the battery module; determine an actual current value of the heating circuit according to the voltage value and the effective resistance value of the heating circuit; and obtain a detection result by at least detecting validity of the first current sampling value according to the actual current value.

Optionally, the heating circuit includes a heating apparatus.

The management apparatus is configured to: obtain a temperature value of the heating apparatus; and
determine a resistance value corresponding to the temperature value according to a preset corresponding relationship between temperature value and resistance value, and determine the resistance value as the effective resistance value of the heating circuit.

Optionally, the heating circuit includes a contactor, and the contactor is connected in series with the heating apparatus.

The management apparatus is further configured to: in response to a request for detecting the validity of the first current sampling value of the battery module, control the contactor to be closed, so that the heating apparatus heats the battery module.

Optionally, the management apparatus is a battery management system BMS.

A third aspect of the present disclosure further provides a non-transitory computer-readable storage medium, and the non-transitory computer-readable storage medium stores a computer program. When the program is executed by a processor, the steps of the method according to the first aspect of the present disclosure are implemented.

A fourth aspect of the present disclosure further provides an electrically powered device, including:
a battery system, where the battery system includes a battery module and a heating circuit, the battery module is connected in parallel with the heating circuit, and the heating circuit is configured to heat the battery module;
a memory, where the memory stores a computer program; and
a processor, configured to execute the computer program in the memory to implement the steps of the method according to the first aspect of the present disclosure.

In the technical solutions mentioned above, when the battery module is in the conducting state and the heating circuit heats the battery module, the voltage value and the effective resistance value of the heating circuit are obtained, and the first current sampling value of the battery module is obtained, the actual current value of the heating circuit is determined according to the voltage value and the effective resistance value of the heating circuit, and the detection result is obtained by at least detecting the validity of the first current sampling value according to the actual current value. In this way, an objective of detecting the validity of the current sampling value of the battery module can be achieved, reliability of monitoring the battery module is improved, and the safety of the vehicle is further improved. In addition, there is no need to additionally increase a structure and costs of the battery system, and an occupied space of the battery system is reduced. In addition, the actual current value of the heating circuit is determined according to the voltage value and the effective resistance value of the heating circuit, so that the actual current value can be determined through a simple calculation, thereby simplifying a process of determining the actual current value.

Other features and advantages of the present disclosure will be described in detail in the subsequent description of embodiments.

### BRIEF DESCRIPTION OF DRAWINGS

The accompanying drawings are intended to provide a further understanding of the present disclosure and constitute a part of the specification, and are used together with the following specific implementations to explain the present disclosure, but do not constitute a limitation on the present disclosure. In the accompanying drawings:
FIG. 1 is a flowchart of a current validity detection method according to an example embodiment;
FIG. 2 is a block diagram of a power supply system according to an example embodiment;
FIG. 3 is a schematic diagram of a power supply system according to an example embodiment;
FIG. 4 is a schematic diagram of a current validity detection method according to an example embodiment; and
FIG. 5 is a flowchart of a method for detecting validity of a first current sampling value according to an example embodiment.

### DESCRIPTION OF EMBODIMENTS

The particular implementations of the present disclosure will be described in detail below in combination with the accompanying drawings. It should be understood that the particular implementations described herein are merely intended to describe and explain the present disclosure and are not intended to limit the present disclosure.

In an actual monitoring process, a current collection unit sends a collected current to a controller or a battery management unit, and the controller or the battery management unit directly monitors a charging/discharging state or power of a battery according to the current collected by the current collection unit, without detecting validity of the current. When a drift current occurs in the current collection unit or the current collection unit is faulty, the current detected by the current collection unit is invalid. If the battery is monitored according to the invalid current, misjudgment or missed judgment of a fault such as overcurrent may occur, which poses a safety risk.

In a related technology, a dual current detection apparatus is usually disposed in a main circuit of a battery pack, and validity of a current is detected by comparing currents collected by the dual current detection apparatus. However, considering that when a battery module includes a plurality of parallel battery branches, if each branch is provided with a dual current detection apparatus, a structure of the battery system becomes relatively large, which occupies a large space and causes relatively high costs.

In view of this, the present disclosure provides a current validity detection method, a power supply system, a medium, and a device, so that validity detection is performed on a current of the battery system without additionally increasing the structure and the costs of the battery system, thereby improving accuracy of monitoring the battery system and further improving safety of a vehicle.

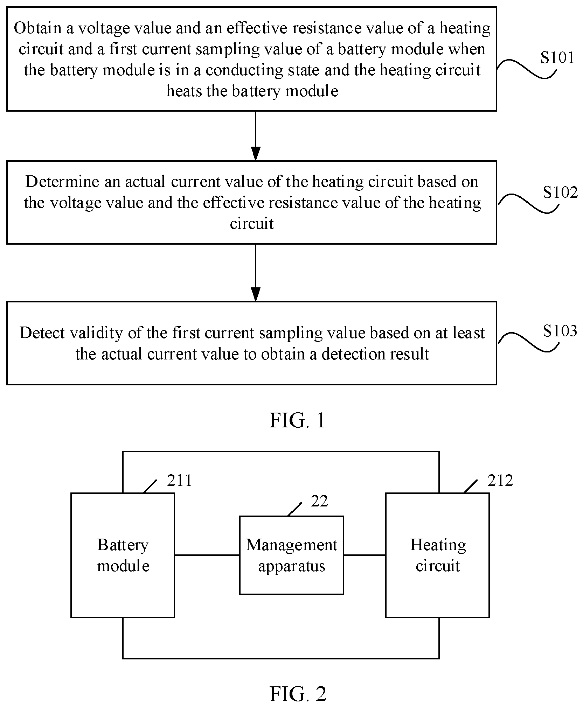

FIG. 1 is a flowchart of a current validity detection method according to an example embodiment. As shown in FIG. 1, the method may include the following steps.

In step S101, when a battery module is in a conducting state and a heating circuit heats the battery module, a voltage value and an effective resistance value of the heating circuit, and a first current sampling value of the battery module are obtained.

A battery system includes the battery module and the heating circuit connected in parallel. The first current sampling value is an output current sampling value of the battery module.

In the present disclosure, the current validity detection method may be performed by a management apparatus, and the management apparatus may include a controller, for example, a vehicle controller, or may include a battery management system BMS. For ease of description, in the present disclosure, an example in which the current validity detection method is performed by the battery management system is used for description.

In step S102, an actual current value of the heating circuit is determined according to the voltage value and the effective resistance value of the heating circuit.

For example, a ratio of the voltage value of the heating circuit to the effective resistance value of the heating circuit is determined as the actual current value of the heating circuit.

In step S103, a detection result is obtained by at least detecting validity of the first current sampling value according to the actual current value.

In the foregoing technical solution, when the battery module is in the conducting state and the heating circuit heats the battery module, the voltage value and the effective resistance value of the heating circuit, and the first current sampling value of the battery module are obtained. The actual current value of the heating circuit is determined according to the voltage value and the effective resistance value of the heating circuit. The detection result is obtained by at least detecting validity of the first current sampling value according to the actual current value. In this way, an objective of detecting the validity of the current sampling value of the battery module can be achieved, reliability of monitoring the battery module is improved, and safety of a vehicle is further improved. In addition, there is no need to additionally increase a structure and costs of the battery system, and an occupied space of the battery system is reduced. In addition, the actual current value of the heating circuit is determined according to the voltage value and the effective resistance value of the heating circuit, so that the actual current value can be determined through a simple calculation, thereby simplifying a process of determining the actual current value.

In order to better understand the current validity detection method provided in the present disclosure, a complete embodiment is provided below to describe the current validity detection method in detail.

FIG. 2 is a block diagram of a power supply system according to an example embodiment. As shown in FIG. 2, the power supply system includes a battery system and a management apparatus 22. The battery system includes a battery module 211 and a heating circuit 212. The battery module 211 and the heating circuit 212 are connected in parallel, and the heating circuit 212 is configured to heat the battery module 211. The management apparatus 22 is separately connected to the battery module 211 and the heating circuit 212. The management apparatus 22 is configured to obtain a voltage value and an effective resistance value of the heating circuit, and obtain a first current sampling value of the battery module when the battery module is in a conducting state and the heating circuit heats the battery module, where the first current sampling value is an output current sampling value of the battery module; determine an actual current value of the heating circuit according to the voltage value and the effective resistance value of the heating circuit; and a detection result is obtained by at least detecting validity of the first current sampling value according to the actual current value.

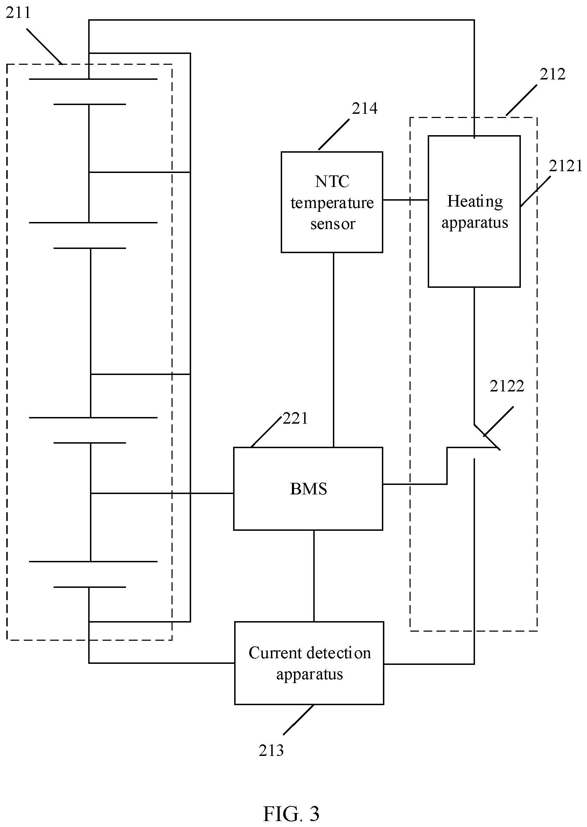

FIG. 3 is a schematic diagram of a power supply system according to an example embodiment. The management apparatus 22 includes a battery management system BMS 221. As shown in FIG. 3, the battery module 211 may include a plurality of batteries connected in series, or the battery module 211 may include a plurality of parallel branches, and each branch includes at least one battery. In a branch including a plurality of batteries, the plurality of batteries are connected in series, and each of the batteries may include a plurality of cells. In FIG. 3, an example in which the battery module 211 includes two batteries connected in series and each battery includes two cells is used for description.

One end of the heating circuit 212 is connected to one end of the battery module 211, and the other end of the heating circuit 212 is connected to the other end of the battery module 211. The heating circuit 212 is configured to heat the battery module 211.

In addition, as shown in FIG. 3, a current detection apparatus 213 may further be provided between the battery module 211 and the heating circuit 212. For example, one end of the heating circuit 212 is connected to one end of the battery module 211 through the current detection apparatus 213. The current detection apparatus 213 may be a current sensor, for example, a Hall current sensor. This is not specifically limited in the present disclosure.

As shown in FIG. 3, the BMS 221 is connected to the current detection apparatus 213 and is configured to obtain a first current sampling value by using the current detection apparatus 213.

For example, the first current sampling value may be a current value of the battery module 211 collected by the current detection apparatus 213 in FIG. 3. Correspondingly, the BMS 221 obtains the first current sampling value from the current detection apparatus 213. For example, the first current sampling value may alternatively be a current value obtained by parsing a current signal collected by the current detection apparatus 213. Correspondingly, the BMS 221 obtains a current signal from the current detection apparatus 213 and parses the current signal to obtain the first current sampling value.

Obtaining an effective resistance value of the heating circuit may include the following steps.

Step (1): Obtain a temperature value of a heating apparatus in the heating circuit.

In the present disclosure, the heating apparatus is disposed in the heating circuit. For example, as shown in FIG. 3, a heating apparatus 2121 is disposed in the heating circuit 212, and the heating apparatus 2121 may be a heating film. In addition, in FIG. 3, the battery system 21 may further include a temperature sensor, and the temperature sensor may be an NTC temperature sensor 214.

In FIG. 3, the NTC temperature sensor 214 is connected to the heating apparatus 2121 and is configured to collect a temperature value of the heating apparatus 2121. The BMS 221 is further connected to the NTC temperature sensor 214 and is configured to obtain the temperature value of the heating apparatus 2121 by using the NTC temperature sensor 214.

Step (2): Determine a resistance value corresponding to the temperature value according to a preset corresponding relationship between temperature value and resistance value, and determine the resistance value as the effective resistance value of the heating circuit.

For example, the BMS 221 is configured to obtain the temperature value of the heating apparatus, determine the resistance value corresponding to the temperature value according to the preset corresponding relationship between temperature value and resistance value, and determine the resistance value as the effective resistance value of the heating circuit.

It should be understood that the effective resistance value of the heating apparatus changes with a temperature and an aging degree of the heating apparatus. In the present disclosure, in order to accurately calculate the effective resistance value of the heating circuit and further accurately determine the actual current value of the heating circuit, the corresponding relationship between temperature value and resistance value may be calibrated in advance according to the aging degree of the heating apparatus. Then, after the temperature value of the heating apparatus in the heating circuit is obtained, the resistance value corresponding to the temperature value is determined according to the corresponding relationship, and the resistance value is determined as the effective resistance value of the heating circuit.

In the foregoing technical solution, considering a case that a temperature affects the effective resistance value of the heating circuit, the effective resistance value of the heating circuit is determined according to the temperature value of the heating apparatus. In this way, the effective resistance value of the heating circuit can be accurately determined, thereby improving accuracy of the determined actual current value of the heating circuit.

Optionally, a contactor is further disposed in the heating circuit, and the contactor is connected in series with the heating apparatus. The current validity detection method further includes:
in response to a request for detecting the validity of the first current sampling value of the battery module, controlling the contactor to be closed, so that the heating apparatus heats the battery module.

For example, the BMS 221 is configured to: in response to the request for detecting the validity of the first current sampling value of the battery module, control the contactor to be closed, so that the heating apparatus heats the battery module.

As shown in FIG. 3, the contactor may be a switch 2122. One end of the switch 2122 is connected to the heating apparatus 2121, and the other end of the switch 2122 is connected to the current detection apparatus 213. The BMS 221 is also connected to the switch 2122. In response to the request for detecting the validity of the first current sampling value of the battery module, the BMS 221 controls the switch 2122 to be closed, so that the heating apparatus 2121 heats the battery module 211.

Obtaining the voltage value of the heating circuit may include the following steps.

Step (3): Obtain a voltage of each cell in the battery module.

For example, as shown in FIG. 3, the BMS 221 is connected to each cell in the battery module 211 to obtain the voltage of each cell in the battery module.

Step (4): Determine a total voltage of the battery module according to the voltage of each cell.

Step (5): Determine the total voltage as the voltage value of the heating circuit.

In FIG. 3, a sum of the voltage of each cell can be determined as the total voltage of the battery module, and the total voltage is determined as the voltage value of the heating circuit. First, it should be understood that if the battery module further includes batteries connected in parallel, there is a need to determine the total voltage of the battery module according to an actual connection manner of the batteries in the battery module. Second, it should be understood that in the present disclosure, a voltage of the current detection apparatus 213 can be ignored, and therefore, the total voltage of the battery module can be determined as the voltage value of the heating circuit.

In an embodiment, validity of the total voltage of the battery module can further be detected. For example, the battery system may further include a voltage collection apparatus. The voltage collection apparatus is connected to the battery module and is configured to collect a voltage across the battery module.

In this embodiment, obtaining the voltage value of the heating circuit further includes the following steps.

Step (6): Obtain a voltage across the battery module by using a voltage collection apparatus.

Step (7): Detect validity of the total voltage according to the voltage across the battery module.

For example, a voltage deviation value between the voltage across the battery module and the total voltage is determined, for example, an absolute value of a difference between the voltage across the battery module and the total voltage as the voltage deviation value. When the voltage deviation value is less than or equal to a preset voltage deviation threshold, it is determined that the total voltage is valid.

Accordingly, a specific implementation of the step (5) is as follows: when the total voltage is determined to be valid, the total voltage is determined as the voltage value of the heating circuit.

In the foregoing technical solution, the validity of the total voltage of the battery module is detected by using the voltage across the battery module collected by the voltage collection apparatus. When the voltage deviation value between the voltage across the battery module and the total voltage is small, it is determined that the voltage of each cell collected by the BMS is accurate, that is, the determined voltage value of the heating circuit is accurate. In this way, the actual current value of the heating circuit can be accurately calculated according to the voltage value of the heating circuit, which further improves accuracy of validity detection on the first current sampling value.

In the foregoing manner, the voltage value and the effective resistance value of the heating circuit are obtained, and then the ratio of the voltage value to the effective resistance value is determined as the actual current value of the heating circuit.

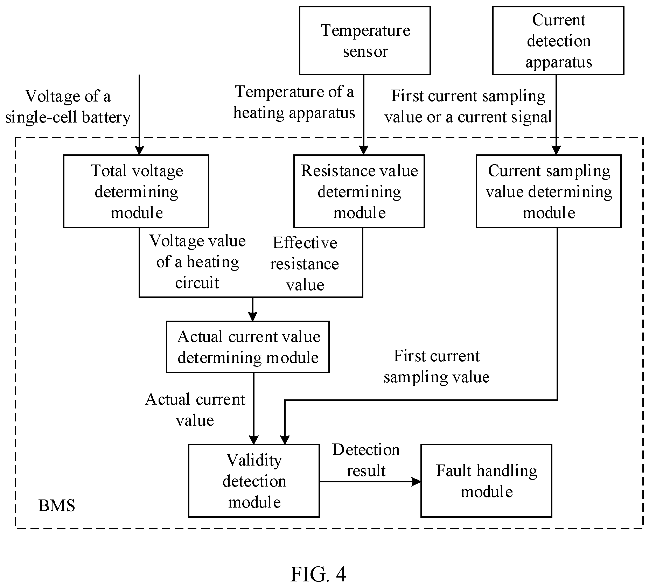

For example, FIG. 4 is a schematic diagram of a current validity detection method according to an example embodiment. As shown in FIG. 4, the BMS may include a total voltage determining module, a resistance value determining module, an actual current value determining module, a current sampling value determining module, and a validity detection module.

The total voltage determining module is configured to obtain a voltage of a cell and determine the voltage value of the heating circuit according to the voltage of the cell. The resistance value determining module is connected to a temperature sensor and stores a precalibrated corresponding relationship between temperature value and resistance value. The resistance value determining module obtains a temperature of the heating apparatus from the temperature sensor, and determines the effective resistance value of the heating circuit according to the temperature of the heating apparatus and the corresponding relationship. The actual current value determining module is connected to the total voltage determining module and the resistance value determining module, and is configured to obtain the voltage value of the heating circuit and the effective resistance value of the heating circuit, and calculate the actual current value of the heating circuit according to the voltage value and the effective resistance value. The current sampling value determining module is connected to the current detection apparatus, and is configured to obtain the first current sampling value from the current detection apparatus, or obtain a current signal from the current detection apparatus and parse the current signal to obtain the first current sampling value. The validity detection module is connected to the actual current value determining module and the current sampling value determining module, and is configured to obtain the actual current value and the first current sampling value, and the detection result is obtained by at least detecting the validity of the first current sampling value according to the actual current value.

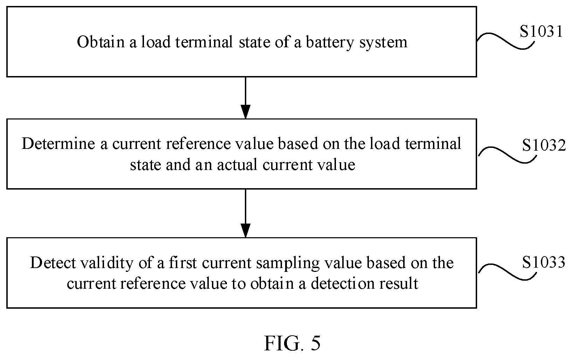

FIG. 5 is a flowchart of a method for detecting validity of a first current sampling value according to an example embodiment. As shown in FIG. 5, step S103 in FIG. 1 may further include the following steps.

In step S1031, a load terminal state of the battery system is obtained.

In an actual application, a load is further connected between a positive terminal and a negative terminal of the battery system. The load may be an electrical accessory on a vehicle, for example, a PTC heater, an air conditioner, or a DC-DC converter. It should be understood that the load terminal state refers to an overall state of the electrical accessory. For example, the load terminal state being a conducting state means that there is a current at a load terminal, that is, at least one electrical accessory is conducted and can operate normally. The load terminal state being a non-conducting state means that there is no current at the load terminal, that is, each electrical accessory is not conducted and cannot operate normally.

In S1032, a current reference value is determined according to the load terminal state and the actual current value.

It should be understood that the first current sampling value is a total current output by the battery module. When the load terminal state is the conducting state, the total current output by the battery module separately flows into the heating circuit and the load terminal. Therefore, when the load terminal state is the conducting state, a current value of the load terminal needs to be further obtained, and a sum of the actual current value and the current value of the load terminal is determined as the current reference value. When the load terminal state is the non-conducting state, the total current output by the battery module all flows into the heating circuit. Therefore, when the load terminal state is the non-conducting state, the actual current value is determined as the current reference value.

In S1033, the validity of the first current sampling value is detected according to the current reference value to obtain the detection result.

For example, the current deviation value between the current reference value and the first current sampling value is determined. An absolute value of a difference between the current reference value and the first current sampling value is determined as the current deviation value. Afterwards, the current deviation value is compared with a preset current deviation threshold. When the current deviation value is greater than the current deviation threshold, it is determined that the first current sampling value is invalid; and when the current deviation value is less than or equal to the current deviation threshold, it is determined that the first current sampling value is valid.

The current deviation threshold is comprehensively set according to voltage sampling accuracy of the cell, sampling accuracy of the current detection apparatus, and an error appeared when the effective resistance value is determined.

It should be understood that it may be determined that the first current sampling value is valid when it is detected that the current deviation value is less than or equal to the current deviation threshold. Alternatively, it may be determined that the first current sampling value is valid when a quantity of times the current deviation value is detected to be less than or equal to the current deviation threshold in preset duration is greater than or equal to a preset quantity of times. Alternatively, it may be determined that the first current sampling value is valid when it is detected in the preset duration that the current deviation value is less than or equal to the current deviation threshold. This is not specifically limited in the present disclosure.

When the detection result indicates that the first current sampling value is invalid, the current validity detection method provided in the present disclosure may further include:
controlling the battery module to switch to the non-conducting state after preset duration; and/or
sending a first invalidity prompt message to a vehicle controller, where the first invalidity prompt message is used to prompt the vehicle controller that the first current sampling value of the battery module is invalid.

For example, as shown in FIG. 4, the BMS may further include a fault handling module, and the fault handling module is connected to the validity detection module. When determining according to the manner described in FIG. 4 that the first current sampling value is invalid, a validity detection module sends a detection result to the fault handling module. The fault handling module controls, according to the detection result, the battery module to switch to the non-conducting state after preset duration. The preset duration may be duration required for controlling an electrical accessory to power off, or may be duration required for a vehicle to pull over, or duration for a vehicle to travel to the nearest repair shop, or the like. This is not specifically limited in the present disclosure.

The fault handling module may report the first invalidity prompt information to the vehicle controller by using a CAN bus.

In addition, when the first current sampling value is determined to be invalid, the validity processing module may further control a state of charge calculation module to calculate a state of charge of the battery module according to the first current sampling value and the preset ratio.

In an embodiment, the current validity detection method may further include:
obtaining a second current sampling value of the battery module when the battery module is in the non-conducting state; and
if the second current sampling value is greater than a zero-drift error threshold, the second current sampling value is determined to be invalid.

In this embodiment, the second current sampling value and the first current sampling value are current values of the battery module collected under different states of the battery module, that is, output current sampling values of the battery module under different states of the battery module.

In the foregoing technical solution, when the battery module is not conducted, validity of the second current sampling value can be detected according to the zero-drift error threshold, so that the accuracy of the validity detection of the current sampling value of the battery module is further improved.

Optionally, when the second current sampling value determined to be invalid, the current validity detection method further includes:
sending a second invalidity prompt message to the vehicle controller, where the second invalidity prompt message is used to prompt the vehicle controller that the second current sampling value of the battery module is invalid; and/or
prohibiting switching the battery module to the conducting state.

Similarly, when the second current sampling value is determined to be invalid, the validity processing module sends the detection result to the fault handling module. The fault handling module sends the second invalidity prompt message to the vehicle controller through the CAN bus according to the detection result, and/or prohibits switching the battery module to the conducting state.

In this way, when it is detected that the second current sampling value is invalid, switching the battery module to the conducting state is prohibited, thereby further improving the safety of the vehicle.

The present disclosure further provides a power supply system, and the system includes: a battery system and a management apparatus. The battery system includes a battery module and a heating circuit connected in parallel. The heating circuit is configured to heat the battery module, and the management apparatus is separately connected to the battery module and the heating circuit.

The management apparatus is configured to: obtain a voltage value and an effective resistance value of the heating circuit, and obtain a first current sampling value of the battery module when the battery module is in a conducting state and the heating circuit heats the battery module, where the first current sampling value is an output current sampling value of the battery module; determine an actual current value of the heating circuit according to the voltage value and the effective resistance value of the heating circuit; and a detection result is obtained by at least detecting validity of the first current sampling value according to the actual current value .

Optionally, the heating circuit includes a heating apparatus.

The management apparatus is configured to obtain a temperature value of the heating apparatus; and
determine a resistance value corresponding to the temperature value according to a preset corresponding relationship between temperature value and resistance value, and determine the resistance value as the effective resistance value of the heating circuit.

Optionally, the heating circuit includes a contactor, and the contactor is connected in series with the heating apparatus.

The management apparatus is further configured to: in response to a request for detecting the validity of the first current sampling value of the battery module, control the contactor to be closed, so that the heating apparatus heats the battery module.

Optionally, the management apparatus includes a battery management system BMS.

The present disclosure further provides a non-transitory computer-readable storage medium, and the non-transitory computer-readable storage medium stores a computer program. When the program is executed by a processor, the steps of the current validity detection method according to the present disclosure are implemented.

The present disclosure further provides an electrically powered device, including: a battery system, where the battery system includes a battery module and a heating circuit, the battery module is connected in parallel with the heating circuit, and the heating circuit is configured to heat the battery module; a memory, where the memory stores a computer program; and a processor, configured to execute the computer program in the memory to implement the steps of the current validity detection method according to the present disclosure.

For example, the electrically powered device may be an electric vehicle, an aircraft, a watercraft, or another device including a battery system.

The foregoing describes in detail example implementations of the present disclosure with reference to the accompanying drawings. However, the present disclosure is not limited to specific details in the foregoing implementations. Multiple simple variations can be made to the technical solutions of the present disclosure within the technical concept scope of the present disclosure, and all these simple variations fall within the protection scope of the present disclosure.

In addition, it should be noted that the specific technical features described in the foregoing specific implementations may be combined in any proper manner without a contradiction. To avoid unnecessary repetition, various possible combination manners are not otherwise described in the present disclosure.

In addition, various different implementations of the present disclosure may be combined arbitrarily, and the combination shall also be considered as the content disclosed in the present disclosure, provided that the combination is not contrary to the idea of the present disclosure.

## Claims

1. A current validity detection method applied to a battery system, wherein the battery system comprises a battery module (211) and a heating circuit (212), the battery module (211) and the heating circuit (212) are connected in parallel, and the method comprises:
when the battery module (211) is in a conducting state and the heating circuit (212) heats the battery module (211), obtaining a voltage value and an effective resistance value of the heating circuit (212), and obtaining a first current sampling value of the battery module (211) (S101), wherein the first current sampling value is an output current sampling value of the battery module (211);
determining an actual current value of the heating circuit (212) according to the voltage value and the effective resistance value of the heating circuit (212) (S102); and
obtaining a detection result by at least detecting validity of the first current sampling value according to the actual current value(S103).

2. The method according to claim 1, wherein a heating apparatus (2121) is disposed in the heating circuit (212), and the obtaining an effective resistance value of the heating circuit (212) comprises:
obtaining a temperature value of the heating apparatus (2121); and
determining a resistance value corresponding to the temperature value according to a preset corresponding relationship between temperature value and resistance value, and determining the resistance value as the effective resistance value of the heating circuit (212).

3. The method according to claim 2, wherein a contactor is further disposed in the heating circuit (212), the contactor is connected in series with the heating apparatus (2121), and the method further comprises:
in response to a request for detecting the validity of the first current sampling value of the battery module (211), controlling the contactor to be closed, so that the heating apparatus (2121) heats the battery module (211).

4. The method according to claim 1, wherein the obtaining a voltage value of the heating circuit (212) comprises:
obtaining a voltage of each cell in the battery module (211);
determining a total voltage of the battery module (211) according to the voltage of each cell; and
determining the total voltage as the voltage value of the heating circuit (212).

5. The method according to claim 4, wherein the obtaining a voltage value of the heating circuit (212) further comprises:
obtaining a voltage across the battery module (211) collected by a voltage collection apparatus; and
detecting validity of the total voltage according to the voltage across the battery module (211); and
the determining the total voltage as the voltage value of the heating circuit (212) comprises:
determining the total voltage as the voltage value of the heating circuit (212) when the total voltage is determined to be valid.

6. The method according to claim 5, wherein the detecting validity of the total voltage according to the voltage across the battery module (211) comprises:
determining a voltage deviation value between the voltage across the battery module (211) and the total voltage; and
when the voltage deviation value is less than or equal to a preset voltage deviation threshold, the total voltage is determined to be valid.

7. The method according to any one of claims 1 to 6, wherein the obtaining a detection result by at least detecting validity of the first current sampling value according to the actual current value comprises:
obtaining a load terminal state of the battery system (S1031), wherein the load terminal state comprises a conducting state and a non-conducting state;
determining a current reference value according to the load terminal state and the actual current value (S1032); and
obtaining a detection result by at least detecting the validity of the first current sampling value according to the current reference value(S1033).

8. The method according to claim 7, wherein the obtaining a detection result by at least detecting the validity of the first current sampling value according to the current reference value comprises:
determining a current deviation value between the current reference value and the first current sampling value;
when the current deviation value is greater than a current deviation threshold, the first current sampling value is determined to be invalid; and
when the current deviation value is less than or equal to the current deviation threshold, the first current sampling value is determined to be valid.

9. The method according to claim 7 or 8, wherein the determining a current reference value according to the load terminal state and the actual current value comprises:
when the load terminal state is in the non-conducting state, determining the actual current value as the current reference value; and
when the load terminal state is in the conducting state, obtaining a current value of the load terminal, and determining a sum of the actual current value and the current value of the load terminal as the current reference value.

10. The method according to any one of claims 1 to 9, wherein when the detection result indicates that the first current sampling value is invalid, the method further comprises:
controlling the battery module (211) to switch to the non-conducting state after preset duration; and/or
sending a first invalidity prompt message to a vehicle controller, wherein the first invalidity prompt message is configured to prompt the vehicle controller that the first current sampling value of the battery module (211) is invalid.

11. The method according to any one of claims 1 to 10, wherein the method further comprises:
when the battery module (211) is in the non-conducting state, obtaining a second current sampling value of the battery module (211); and
if the second current sampling value is greater than a zero-drift error threshold, the second current sampling value is determined to be invalid.

12. The method according to claim 11, wherein when the second current sampling value is determined to be invalid, the method further comprises:
sending a second invalidity prompt message to the vehicle controller, wherein the second invalidity prompt message is configured to prompt the vehicle controller that the second current sampling value of the battery module (211) is invalid; and/or
prohibiting switching the battery module (211) to the conducting state.

13. The method according to any one of claims 1 to 12, wherein the battery module (211) comprises a plurality of batteries connected in series, or the battery module (211) comprises a plurality of parallel branches, and each branch comprises at least one battery.

14. A power supply system, the system comprising a battery system and a management apparatus (22);
the battery system comprising a battery module (211) and a heating circuit (212), connected in parallel, wherein the heating circuit (212) is configured to heat the battery module (211);
the management apparatus (22) being separately connected to the battery module (211) and the heating circuit (212); and
the management apparatus (22) being configured to: when the battery module (211) is in a conducting state and the heating circuit (212) heats the battery module (211), obtain a voltage value and an effective resistance value of the heating circuit (212), and obtain a first current sampling value of the battery module (211)(S101), wherein the first current sampling value is an output current sampling value of the battery module (211); determine an actual current value of the heating circuit (212) according to the voltage value and the effective resistance value of the heating circuit (212) (S102); and obtain a detection result by at least detecting validity of the first current sampling value according to the actual current value(S103).

15. The power supply system according to claim 14, wherein the heating circuit (212) comprises a heating apparatus (2121);
the management apparatus (22) is configured to: obtain a temperature value of the heating apparatus (2121); and
determine a resistance value corresponding to the temperature value according to a preset corresponding relationship between temperature value and resistance value, and determine the resistance value as the effective resistance value of the heating circuit (212).

16. The power supply system according to claim 15, wherein the heating circuit (212) comprises a contactor, and the contactor is connected in series with the heating apparatus (2121); and
the management apparatus (22) is further configured to: in response to a request for detecting the validity of the first current sampling value of the battery module (211), control the contactor to be closed, so that the heating apparatus (2121) heats the battery module (211).

17. The power supply system according to any one of claims 14 to 16, wherein the management apparatus (22) comprises a battery management system BMS (221).

18. A non-transitory computer-readable storage medium, wherein the non-transitory computer-readable storage medium stores a computer program, and when the program is executed by a processor, the steps of the method according to any one of claims 1 to 13 are implemented.

19. An electrically powered device, comprising:
a battery system, wherein the battery system comprises a battery module (211) and a heating circuit (212), the battery module (211) is connected in parallel with the heating circuit (212), and the heating circuit (212) is configured to heat the battery module (211);
a memory, wherein the memory stores a computer program; and
a processor, configured to execute the computer program in the memory to implement the steps of the method according to any one of claims 1 to 13.
